# EUROPÄISCHE PATENTSCHRIFT

(11) **EP 1 512 981 B1**
(45) Veröffentlichungstag und Bekanntmachung des Hinweises auf die Patenterteilung: **31.10.2007**
(21) Anmeldenummer: 03405641.6
(22) Anmeldetag: 03.09.2003
(51) Int. Cl.: G01R 15/24

(54) **Temperaturstabilisierte Sensorspule und Stromsensor**
Temperature stabilized sensing coil and current sensor
Bobine de détection et détecteur de courant stabilisés contre les variations de la température

(43) Veröffentlichungstag der Anmeldung: 09.03.2005
(73) Patentinhaber: ABB RESEARCH LTD., 8050 Zürich (CH)
(72) Erfinder: Bohnert, Klaus, 5452 Oberrohdorf (CH); Gabus, Philippe, 5400 Baden (CH); Brändle, Hubert, 8102 Oberengstringen (CH)
(74) Vertreter: ABB Patent Attorneys

(56) Entgegenhaltungen:
- EP-A- 0 856 737
- DE-A- 19 802 191
- US-A- 4 255 018
- US-A- 5 500 909
- PATENT ABSTRACTS OF JAPAN vol. 007, no. 032 (P-174), 8. Februar 1983 (1983-02-08) -& JP 57 184973 A (FUJITSU KK), 13. November 1982 (1982-11-13)
- BOHNERT K ET AL: "TEMPERATURE AND VIBRATION INSENSITIVE FIBER-OPTIC CURRENT SENSOR" JOURNAL OF LIGHTWAVE TECHNOLOGY, IEEE. NEW YORK, US, Bd. 20, Nr. 2, Februar 2002 (2002-02), Seiten 267-276, XP001126277 ISSN: 0733-8724
- PATENT ABSTRACTS OF JAPAN vol. 2000, no. 07, 29. September 2000 (2000-09-29) -& JP 2000 111586 A (TOSHIBA CORP;TOSHIBA HENDEN KIKI TECHNOLOGY KK), 21. April 2000 (2000-04-21)

## Beschreibung

### Technisches Gebiet

Die Erfindung bezieht sich auf das Gebiet der faseroptischen Sensorik. Sie bezieht sich auf einen Sensorkopf und einen Strom- oder Magnetfeldsensor gemäss dem Oberbegriff der unabhängigen Patentansprüche.

### Stand der Technik

Ein derartiger Sensorkopf ist beispielsweise aus EP 0'856'737 A1 bekannt. Dort ist ein faseroptischer Stromsensor beschrieben mit einem Sensorkopf, der eine in einer Kapillare angeordnete Sensorfaser beinhaltet. Die Sensorfaser ist von ihrer Faserschutzhülle befreit und danach thermisch behandelt, um mechanische Spannungen auszuheilen, die zu störenden Einflüssen durch ungewollte Doppelbrechung führen. Dadurch wird eine verbesserte Temperaturstabilität der Sensormessungen erreicht. In die Kapillare ist ein Schutzgas oder auch ein Öl zu dem Zwecke eingebracht, das Eindringen von Feuchtigkeit oder chemisch aggressiven Dämpfen in das Kapillareninnere zu verhindern, wodurch die faserschutzhüllenfreie Sensorfaser chemisch beschädigt werden könnte.

Ein solcher Sensorkopf hat den Nachteil, dass er schwierig zu montieren ist und kaum zur temperaturstabilen Messung von Strömen in Stromleitern grossen Durchmessers geeignet ist.

Aus dem Stand der Technik sind noch die folgenden Möglichkeiten zur Unterdrückung störender Doppelbrechung in optischen Fasern bekannt: Die Verwendung von "Hibi spun"-Fasern. Bei "Hibi spun"-Fasern wird störende lineare Doppelbrechung durch eingefrorene zirkulare Doppelbrechung unterdrückt. Nachteilig ist dabei, dass sich das Mess-Signal relativ stark mit der Temperatur ändert (typischerweise mehrere Prozent pro 100 °C). Es können auch Fasern aus Flintglas eingesetzt werden. Die elasto-optischen Koeffizienten von Flintglas sind sehr klein, so dass externe Kräfte nur geringe lineare Doppelbrechung hervorrufen. Doch Flintglasfasern haben aber im Vergleich zu Quarzglasfasern eine geringere chemische und mechanische Beständigkeit, und eine Schmelzverbindung (Faserspleiss, fusion splice) mit einer Zuleitungsfaser oder einem Phasenverzögerungselement aus Quarzglas ist nicht möglich. Ausserdem ist die Verwendung von mechanisch tordierten Fasern bekannt. Aber entsprechende Spulen sind umständlich herzustellen, und ihre Langzeitzuverlässigkeit ist fraglich.

In der JP-A-57184973 wird ein elektrischer Stromsensor offenbart, bei dem eine Rogowsky-Spule auf einen zylindrischen, elastisch biegbaren Trägerkörper gewickelt und dieser um einen Stromleiter herum angeordnet ist.

### Darstellung der Erfindung

Es ist deshalb Aufgabe der Erfindung, einen Sensorkopf und einen Strom- oder Magentfeldsensor der eingangs genannten Art zu schaffen, welche die oben genannten Nachteile nicht aufweisen. Insbesondere soll eine weitgehend temperaturunabhängige Strom- oder Magnetfeldmessung mit einem gut montierbaren Sensorkopf geschaffen werden, der Messungen mit grossen Sensorspulendurchmessern erlaubt, wie sie beispielsweise für die Messung von Strömen in Stromleitern mit grossem Querschnitt nötig sind.

Diese Aufgabe lösen ein Sensorkopf und ein Sensor mit den Merkmalen der unabhängigen Patentansprüche.

Ein erfindungsgemässer faseroptischer Sensorkopf für einen Strom- oder Magnetfeldsensor umfasst
- eine optische Faser, welche eine magnetooptisch aktive Sensorfaser und mindestens eine Zuleitungsfaser in optischer Verbindung beinhaltet, wobei die Sensorfaser befreit ist von ihrer Faserschutzhülle, und
- eine Kapillare, in welcher mindestens die Sensorfaser angeordnet ist und in der ein Mittel vorhanden ist.
Er kennzeichnet sich dadurch aus, dass der Sensorkopf im Bereich der Sensorfaser biegbar ist, die Sensorfaser eine nicht bei mindestens der Erweichungstemperatur des Sensorfasermaterials thermisch behandelte Faser ist und das Mittel ein Reibungsverminderungsmittel ist, das zur Verringerung von Reibungskräften zwischen der Sensorfaser und der Kapillare dient.

Dadurch wird es möglich, den Sensorkopf einfach zu montieren und trotzdem temperatur- und biegungsabhängige Störeinflüsse auf mittels des Sensorkopfes gemachte Messungen weitgehend zu eliminieren. Bei den aus der genannten EP 0'856'737 A1 bekannten Sensorköpfen ist die Sensorfaser bei ihrer Erweichungstemperatur für einige Zeit getempert. Durch eine solche thermische Behandlung erhält die Sensorfaser eine feste Form. Ihre mechanische Bruchspannung ist reduziert. Versucht man, eine solche Sensorfaser zu verformen, so wird sie zerbrechen oder zumindest wird neue, grosse, unerwünschte Doppelbrechung in der Faser induziert, so dass das Ziel der thermischen Behandlung, nämlich die Befreiung der Sensorfaser von Doppelbrechung, wieder zunichte gemacht wird.

Doppelbrechung in der Sensorfaser ist unerwünscht, insbesondere wenn sie noch eine Abhängigkeit von der Temperatur aufweist, da durch die Doppelbrechung ein beispielsweise zirkularer Polarisationszustand von sich in der Sensorfaser ausbreitendem Licht nicht erhalten bleibt, sondern gestört wird. Um einen Messfehler von unter etwa 0.2 % zu erhalten, sollte eine durch Doppelbrechung hervorgerufene Phasenverschiebung über den gesamten relevanten Temperaturbereich möglichst nicht über etwa 10° gross sein und sich höchstens um einige wenige Grad ändern. Die Doppelbrechung entsteht durch die Einwirkung äusserer Kräfte auf die Sensorfaser.

Es hat sich aber gezeigt, dass, insbesondere bei Spulen grossen Durchmessers und entsprechend grossen Krümmungsradien der Sensorfaser, der Einfluss der durch das Krümmen der Sensorfaser selbst induzierten Doppelbrechung weniger gross ist als der Einfluss solcher unerwünschter Doppelbrechungen, die beim Biegen des Sensorkopfes zu einer Spule durch Reibungskräfte zwischen der Kapillare und der in der Kapillare angeordneten Faser induziert werden. Die erstgenannten biegungsinduzierten Doppelbrechung belaufen sich beispielsweise bei einem Spulendurchmesser von 1 m, einem Faserdurchmesser von 80 µm und einer Lichtwellenlänge von 800 nm auf etwa 1.1 ° pro Windung der Spule. Die letztgenannten Doppelbrechungen zeigen einerseits eine nichtreproduzierbare Temperaturabhängigkeit, so dass ein mittels des Sensorkopfes erhaltenes Mess-Signal in unerwünschter Weise temperaturabhängig ist. Andererseits ändern sich die Reibungskräfte und die durch sie hervorgerufene Doppelbrechung, wenn die Spule, beispielsweise für Transport und Montage, geöffnet und geschlossen wird oder in anderer Weise in ihrer Form verändert wird. Die Folge ist eine unerwünschte Änderung der Messempfindlichkeit und/oder der Eichung des Sensors. Auch kann sich bei Temperaturveränderungen auch die gegenseitige Anordnung von Faser und Kapillare ändern, wodurch aufgrund von Wechselwirkungskräften zwischen Faser und Kapillare bei Temperaturänderungen weitere unerwünschte Veränderungen der Doppelbrechung der Sensorfaser auftreten. Diese reibungsbedingten unerwünschten Doppelbrechungen können durch das Reibungsverminderungsmittel weitgehend vermieden werden.

Dadurch, dass der Sensorkopf biegbar ist und trotzdem eine nur sehr geringe Doppelbrechung aufweist, kann er leicht montiert werden. Wenn beispielsweise ein durch einen Stromleiter fliessender Strom gemessen werden soll, braucht der Stromleiter nicht unterbrochen zu werden, um die Sensorfaser um den Stromleiter zu legen. Auch die Geometrie einer aus dem Sensorkopf zu formenden Spule braucht nicht vorgegeben zu sein. Die Spulenform kann, je nach Anwendung (Stromleiterquerschnittsgeometrie) beispielsweise rund, elliptisch, oval oder hippodromförmig sein. Und es können eine, zwei oder mehr Spulenwindungen erzeugt werden, so dass der Sensorkopf flexibel an ein Messproblem anpassbar ist.

Die magnetooptische Aktivität der Sensorfaser bedeutet, dass sie eine nichtverschwindende Verdet-Konstante aufweist.

Die Zuleitungsfaser dient der Führung von Licht und der optischen Verbindung des Sensorkopfes mit einem optoelektronischen Modul, das der Erzeugung und Detektion von Licht und der Auswertung von Mess-Signalen dient.

Dass die Sensorfaser von ihrer Faserschutzhülle befreit ist, vermeidet die Induzierung unerwünschter Doppelbrechung durch mechanische Kräfte, die die Faserschutzhülle auf die Faser ausübt, die bei Temperaturveränderungen im allgemeinen auftreten, da im allgemeinen die thermischen Ausdehnungskoeffizienten von Faserschutzhülle und Cladding verschieden sind. Solche störende Doppelbrechungen führen typischerweise zu Messungenauigkeiten von 1 % bis 2 % und mehr.

Die Kapillare übernimmt den mechanischen Schutz der von der Faserschutzhülle befreiten Faser.

Erfindungsgemäß ist die Sensorfaser nicht bei mindestens der Erweichungstemperatur des Sensorfasermaterials thermisch behandelt. Dadurch verbleibt die Sensorfaser in einem besonders biegsamen Zustand, wodurch die Herstellung von Sensorköpfen für Spulen grossen Durchmessers und die Montage des Sensorkopfes deutlich vereinfacht ist.

In einer weiteren vorteilhaften Ausführungsform weist die Sensorfaser im montierten Zustand einen Krümmungsradius von mindestens 0.25 m, insbesondere mindestens 0.4 m oder mindestens 0.5 m auf. Bei solch grossen Krümmungsradien und entsprechenden Spulendurchmessern ist die durch die Biegung der Sensorfaser induzierte Doppelbrechung relativ gering. Ausserdem können bei so grossen Spulendurchmessern Ströme in Leitern sehr grossen Querschnitt gemessen werden, wie sie beispielsweise in der Aluminiumherstellung vorkommen.

In einer besonders vorteilhaften Ausführungsform ist ein Teil der mindestens einen Zuleitungsfaser innerhalb der Kapillare angeordnet. Diese Ausführungsform hat den Vorteil, dass auch ein Teil der Zuleitungsfaser durch die Kapillare mechanisch geschützt ist. Ausserdem kann in dieser Ausführungsform eine eventuell an mindestens einem Kapillarenende vorgesehene Halterung oder ein dort vorgesehenes Verschliessmittel mechanisch mit der typischerweise mechanisch gegenüber der Sensorfaser unempfindlichen Zuleitungsfaser verbunden sein, so dass durch die Halterung oder das Verschliessmittel in der Sensorfaser keine störende Doppelbrechung induziert wird.

Vorteilhaft bestehen sowohl die Kapillare als auch die Sensorfaser im wesentlichen aus Quarzglas. Dadurch weisen beide denselben thermischen Ausdehnungskoeffizienten auf, und ausserdem ist die Erzeugung von Faserspleissen aus Quarzglas einfach.

In einer weiteren vorteilhaften Ausführungsform ist die Kapillare von einer Kapillarenummantelung ummantelt. Dadurch werden Mikrorisse, die bei häufigem Biegen des Sensorkopfes an der Oberfläche der Kapillare auftreten, vermieden. Solche Mikrorisse können zum Bruch der Kapillare führen.

Vorteilhaft ist die Kapillare innerhalb eines Faserschutzhohlkabels angeordnet. Das Faserschutzhohlkabel dient dem Schutz der Faser und der Kapillare vor mechanischen Einflüssen von aussen.

Besonders vorteilhaft ist das Reibungsverminderungsmittel eine Flüssigkeit, insbesondere ein ÖI, oder ein Pulver.

In einer bevorzugten Ausführungsform ist die Kapillare an ihren Enden mittels eines Verschliessmittels verschlossen und enthält als Reibungsverminderungsmittel eine Flüssigkeit, und enthält zur Aufnahme temperaturbedingter Volumenänderungen des Reibungsverminderungsmittel ein Gas. Auf diese Weise wird eine über einen grossen Temperaturbereich sicher verschlossene Kapillare realisiert. Über einen gewünschten Temperaturbereich kann die temperaturbedingte Ausdehnungsänderung des Reibungsverminderungsmittels durch das leicht kompressible Gas kompensiert, so dass ein vorgebbarer Minimal- und Maximaldruck in der Kapillare nicht unter- beziehungsweise überschritten wird. Das Gas kann beispielsweise als ein einziges Volumen (eine Säule) an einem Ende der Kapillare oder als zwei, jeweils an einem Ende der Kapillare angeordnete Volumina (Säulen) angeordnet sein, oder auch als noch mehr getrennte Volumina, die entlang der Achse der Kapillare verteilt sind. Insbesondere kann vorteilhaft auch ein Gemisch, eine Emulsion, aus dem Reibungsverminderungsmittel und dem Gas genommen werden. Ein Verschliessen der Kapillare ist generell von Vorteil, wenn das Reibungsverminderungsmittel ausfliessen oder verdunsten kann.

In einer weiteren vorteilhaften Ausführungsform liegt das Reibungsverminderungsmittel als eine dünne reibungsvermindernde Schicht auf der Faser und/oder auf der Innenseite der Kapillare vor. In diesem Fall wird weniger von dem Reibungsverminderungsmittel benötigt. Und es kann in manchen Fällen auf ein Verschliessen der Kapillare verzichtet werden. Die Schichten können beispielsweise Ölfilme sein oder Schichten aus einem Trockenschmiermittel wie MoS₂, oder ein nanotechnologisches Schmiermittel bestehend aus einer einzigen oder einiger weniger Molekülschichten.

Vorteilhaft kann die Kapillare an ihren Enden mittels eines Klebstoffes als Verschliessmittel verschlossen sein. Dadurch kann auf eine einfache Weise ein sicherer Verschluss der Kapillare zum Schutz der Sensorfaser und/oder zur Verhinderung des Austretens des Reibungsverminderungsmittels und gegebenenfalls eines in der Kapillare enthaltenen Gases realisiert werden.

Zum Verschliessen der Kapillare kann vorteilhaft die Kapillare an ihren Enden mit je einem schlauchförmigen Verlängerungsstück versehen werden, wobei die Verlängerungsstücke je einen erstenTeil aufweisen, der jeweils an einem Ende der Kapillare die Kapillare oder gegebenenfalls die Kapillarenummantelung äusserlich umschliesst, und je einen zweiten Teil aufweisen, der das jeweilige Ende der Kapillare in axialer Richtung überragt, wobei das Verschliessmittel in den zweiten Teil der Verlängerungsstücke eingebracht ist.

In einer bevorzugten Ausführungsform beinhaltet die optische Faser mindestens ein Phasenverzögerungselement , welches mit der Sensorfaser und der mindestens einen polarisationserhaltenden Zuleitungsfaser in optischer Verbindung steht, wobei das mindestens eine Phasenverzögerungselement zwischen der Sensorfaser und der mindestens einen Zuleitungsfaser angeordnet ist, und wobei die mindestens eine Zuleitungsfaser eine polarisationserhaltende Faser ist.

In einer weiteren Ausführungsform der letztgenannten bevorzugten Ausführungsform beinhaltet die optische Faser zwei Phasenverzögerungselemente und zwei Zuleitungsfasern, wobei zwischen der Sensorfaser und jeder der zwei Zuleitungsfasern je ein Phasenverzögerungselement angeordnet ist. Ein solcher Sensorkopf ist für Messsungen in Sagnac-Kofiguration geeignet.

Ein erfindungsgemässer Strom- oder Magnetfeldsensor kennzeichnet sich dadurch, dass er einen erfindungsgemässen Sensorkopf aufweist. Die Vorteile des Sensors ergeben sich aus denen des Sensorkopfes.

Weitere bevorzugte Ausführungsformen und Vorteile gehen aus den abhängigen Patentansprüchen und den Figuren hervor.

### Kurze Beschreibung der Zeichnungen

Im folgenden wird der Erfindungsgegenstand anhand von bevorzugten Ausführungsbeispielen, welche in den beiliegenden Zeichnungen dargestellt sind, näher erläutert. Es zeigen schematisch:
- Fig. 1: einen erfindungsgemässen Stromsensor in Sagnac-Konfiguration;
- Fig. 2: einen erfindungsgemässen Stromsensor in Reflexions-Konfiguration;
- Fig. 3: einen erfindungsgemässen Sensorkopf in Sagnac-Konfiguration;
- Fig. 4: einen erfindungsgemässen Sensorkopf in Reflexions-Konfiguration;
- Fig. 5: einen erfindungsgemässen Sensorkopf in hippodromförmiger Spulenform mit einer Windung, in Reflexions-Konfiguration;
- Fig. 6: eine gemessene Temperaturabhängigkeit eines erfindungsgemässen temperaturkompensierten Stromsensors.

Die in den Zeichnungen verwendeten Bezugszeichen und deren Bedeutung sind in der Bezugszeichenliste zusammengefasst aufgelistet. Grundsätzlich sind in den Figuren gleiche oder gleichwirkende Teile mit gleichen Bezugszeichen versehen. Die beschriebenen Ausführungsbeispiele stehen beispielhaft für den Erfindungsgegenstand und haben keine beschränkende Wirkung.

### Wege zur Ausführung der Erfindung

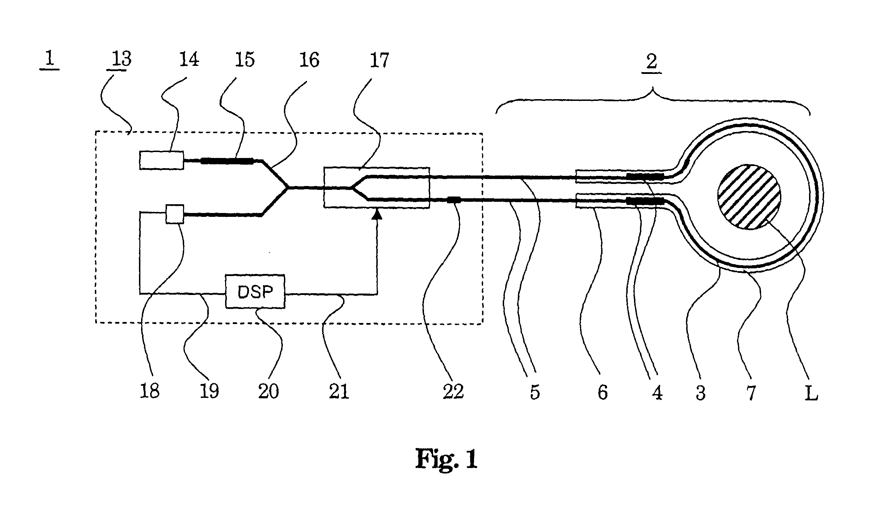

Fig. 1 zeigt schematisch einen erfindungsgemässen Stromsensor 1 in Sagnac-Konfiguration. Der Sensor 1 besteht aus einem optoelektronischen Modul 13 und einem Sensorkopf 2, welche durch zwei vorteilhaft polarisationserhaltende Zuleitungsfasern 5 optisch miteinander verbunden sind. Bis auf einige Details des Sensorkopfes 2 kann der Sensor 1 vorteilhaft so aufgebaut sein wie es in der europäischen Offenlegungsschrift EP 1154278 beschrieben ist. Weiterhin ist der Sensor vorteilhaft auch noch temperaturkompensiert, wie es in der europäischen Offenlegungsschrift EP 1115000 oder in der PCT-Anmeldung mit dem internationalen Aktenzeichen PCT/CH02/00473 (internationaler Anmeldetag 29.08.2002) beschrieben ist.

Der prinzipielle Aufbau und die grundlegende Funktion des Sensors werden hier trotz der in die Beschreibung übernommenen Offenlegungsschriften nocheinmal aufgeführt.

Das optoelektronische Modul 13 beinhaltet eine Lichtquelle 14, vorzugsweise eine Superluminiszenzdiode oder eine unterhalb der Laserschwelle betriebene Laserdiode, und einen Depolarisator 15. Das von der Lichtquelle 14 erzeugte und durch den Depolarisator 15 depolarisierte Licht wird über einen Faserkoppler 16 in einen Phasenmodulator 17 geführt. Vorzugsweise wird als Phasenmodulator 17 ein integriert-optischer Lithiumniobat-Phasenmodulator eingesetzt, welcher in einem geschlossenen Regelkreis (closed loop gyroscope) betrieben wird. Die durch den Strom hervorgerufene Phasenverschiebung wird hierbei in dem optoelektronischen Modul 13 wieder kompensiert. Dies hat den Vorteil einer hohen Messgenaugikeit, eines grossen Dynamikbereichs und einer sehr guten Linearität über den ganzen Messbereich. Der Phasenmodulator 17 wirkt gleichzeitig als ein Polarisator.

Der Phasenmodulator 17 ist über eine Steuerungsleitung 21 mit einem Signalprozessor 20 wirkverbunden und wird von diesem so gesteuert, dass eine nicht-reziproke Phasenmodulation erreicht wird. Der Signalprozessor 20 ist über eine Signalleitung 19 mit einem Detektor 18 wirkverbunden, um detektierte Lichtsignale auszuwerten. Der Detektor 18 ist mit dem zweiten Arm des Faserkopplers 16 optisch verbunden. Vorzugsweise noch innerhalb des optoelektronischen Moduls 13 ist in mindestens einer der zwei Zuleitungsfasern 5 ein Faserspleiss 22 oder ein Steckverbinder 22 vorgesehen. Dort kann die Zuleitungsfaser 5 zur Montage des Sensorkopfes 2 aufgetrennt und wieder geschlossen werden. Im Falle eines Steckverbinders 22 ist dieser vorteilhaft in eine Gehäusewand des optoelektronischen Moduls 13 integriert.

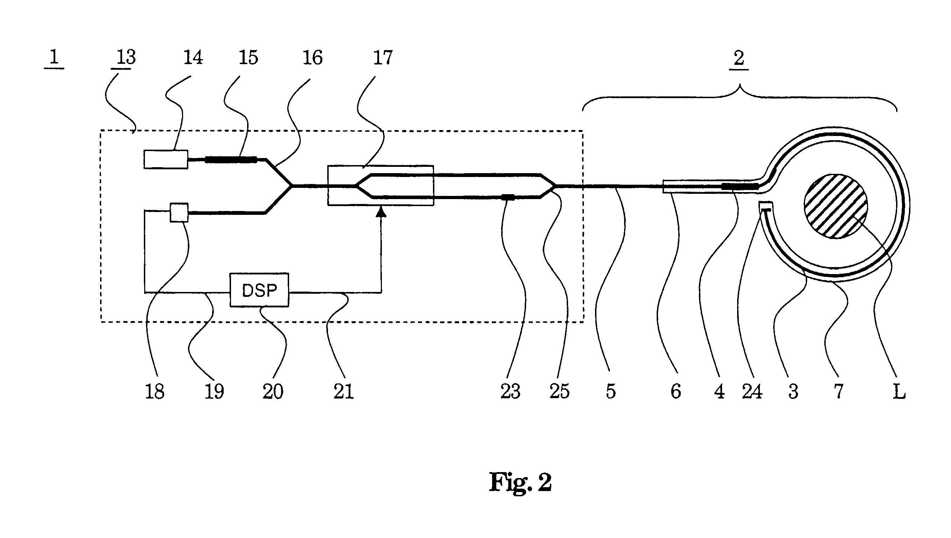

Der Sensorkopf 2 beinhaltet eine Sensorfaser 3, welche an ihren beiden Enden mittels je eines Phasenverzögerungselementes 4 mit je einer Zuleitungsfaser 5 optisch verbunden ist. Die Sensorfaser 2 ist in dem dargestellten montierten Zustand spulenförmig mit, wie dargestellt einer, oder auch zwei oder mehr Windungen, um einen Stromleiter L angeordnet, welcher Stromleiter L einen zu messenden elektrischen Strom I führt. Vorteilhaft ist die Anzahl Windungen, die von dem Sensorkopf 2 gebildet wird, eine ganze Zahl, weil dann ein geschlossener Integrationsweg erreicht wird und somit der Messwert (Strom I) von der Position des Leiters L innerhalb der Spule unabhängig ist. Beim reflektiven Sensor 1 (Fig. 2) liegen dann das Phasenverzögerungselement 4 und der Spiegel 24 nebeneinander. Beim Sagnac-Sensor (Fig. 1) liegen die beiden Phasenverzögerungselemente 4 nebeneinander. Vorteilhaft bestehen Cladding und Kern der Sensorfaser aus Quarzglas. Dies gilt auch für die Phasenverzögerungselemente 4 und die Zuleitungsfasern 5. Der Kernquerschnitt der Sensorfaser 3 ist vorteilhaft rund. Der Kernquerschnitt der Phasenverzögerungselemente 4 und der Zuleitungsfasern ist vorteilhaft elliptisch.

Die Sensorfaser 3 und die Phasenverzögerungselemente 4 sowie jeweils ein Teil der Zuleitungsfasern 5 sind innerhalb einer Kapillare 6 angeordnet. Ausserdem ist in der Kapillare 6 ein Reibungsverminderungsmittel 7 enthalten, beispielsweise ein Silikonöl.

Im Betriebsfall wird die Sensorfaser 3 von zwei gegenläufigen Lichtwellen mit zirkularer oder näherungsweise zirkularer Polarisation gleichen Drehsinns durchlaufen. Die Lichtwellen erfahren eine zu dem Strom I proportionale nicht-reziproke optische Phasenverschiebung Δφₛ, welche im Falle perfekt zirkular polarisierter Wellen Δφₛ = 2VNI beträgt, wobei V die Verdet-Konstante der Sensorfaser 3 ist und N die Anzahl der Faserwindungen der Spule. Der Fall nicht-zirkularer (elliptisch polarisierter) Lichtwellen ist in der genannten europäischen Offenlegungsschrifte EP 1115000 und der genannten PCT-Anmeldung mit dem internationalen Aktenzeichen PCT/CH02/00473 (internationaler Anmeldetag 29.08.2002) sowie in K. Bohnert, P. Gabus, J. Nehring and H. Brändle, "Temperature and vibration insensitive fiber-optic current sensor", Journal of Lightwave Technology, Vol. 20 (2), p.267-276, 2002 beschrieben. In diesen Schriften ist auch der entsprechende Wert für Δφₛ bei elliptischer Polarisation angegeben.

Die zirkularen (oder elliptischen) Wellen werden mit Hilfe der faseroptischen Phasenverzögerungselemente 4 aus sich in den Zuleitungsfasern 5 ausbreitenden linear polarisierten Wellen erzeugt. Beim Verlassen der Sensorfaser 3 wandeln die Phasenverzögerungselemente 4 die zirkularen (oder elliptischen) Wellen in lineare Wellen zurück. Die Phasenverschiebung wird vorzugsweise mit einer Methode und einer entsprechenden optoelektronischen Vorrichtung gemessen, wie sie von faseroptischen Kreiseln bekannt sind. Siehe hierzu auch die Publikation R. A. Bergh, H.C. Lefevre, and H. J. Shaw, "An overview of fiber-optic gyroscopes", J. Lightw. Technol., Vol. 2(2), p.91-107, 1984.

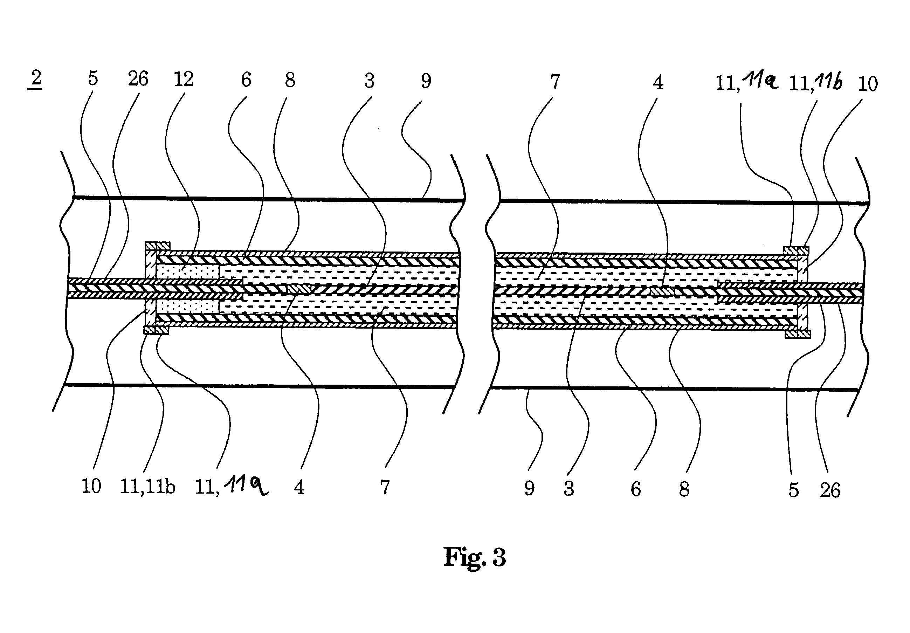

Die weiteren Details des Sensorkopfes 2 sind in Fig. 3 genauer dargestellt und werden im Zusammenhang mit Fig. 3 diskutiert.

Fig. 2 zeigt, analog zu Fig. 1, schematisch einen erfindungsgemässen Stromsensor in Reflexions-Konfiguration. Für das optoelektronische Modul 13 gilt das in Verbindung mit Fig. 1 gesagte, ausser dass kein 0°-Faserspleiss 22 oder Steckverbinder 22 vorgesehen zu sein braucht, weil der Sensorkopf anders als in der Sagnac-Konfiguration keine Schlaufe bildet und somit kein Bedarf besteht, eine Faser für eine Montage zu öffnen. Die zwei Ausgänge des Phasenmodulators 17 werden in einem polarisationserhaltenden Faserkoppler 25 zusammengeführt, wobei in einem der zwei Faserzweige ein 90°-Faserspleiss 23 vorgesehen ist. Der 90°-Faserspleiss 23 ist unnötig, wenn man den Faserkoppler 25 so mit dem Phasenmodulator 17 verbindet, dass an einem Faserende die schnelle Faserachse parallel zur Polarisationsrichtung und am anderen Ende die langsame Achse parallel zur Polarisationsrichtung ausgerichtet ist. Der Ausgang des polarisationserhaltenden Faserkopplers 25 ist mit der Zuleitungsfaser 5 optisch verbunden. Die Zuleitungsfaser 5 ist über ein Phasenverzögerungselement 4 mit einem Ende der Sensorfaser 3 optisch verbunden. Das andere Ende der Sensorfaser 3 ist verspiegelt oder weist einen Spiegel 24 auf. Die Kapillare 6 umschliesst einen Teil des Zuleitungsfaser 5, das Phasenverzögerungselement 4 und die Sensorfaser 3 und enthält ein Reibungsverminderungsmittel 7.

Die von dem Sensorkopf 2 gebildete Faserspule wird von zwei zirkularen oder näherungsweise zirkularen Wellen mit entgegengesetztem Drehsinn und gleicher Ausbreitungsrichtung durchlaufen. Die Wellen werden am verspiegelten Ende 24 der Sensorfaser 3 reflektiert und durchlaufen die Spule ein zweites Mal in umgekehrter Richtung. Die totale durch den Strom I hervorgerufene optische Phasenverschiebung beträgt hier im Falle perfekt zirkular polarisierter Lichtwellen Δφ_{R} = 4VNI. Die beiden zirkular polarisierten Wellen werden mittels des Phasenverzögerumgselementes 4 aus zwei orthogonal zueinander linear polarisierten Wellen erzeugt und beim Verlassen der Spule wieder in orthogonal zueinander linear polarisierte Wellen zurückverwandelt. Die Phasenverschiebung Δφ_{R} wird vorzugsweise mit einer optoelektronischen Vorrichtung gemessen, wie es aus der genannten europäischen Offenlegungsschrift EP 1154278 bekannt ist (modifiertes Kreiselmodul). Ansonsten gilt das in Zusammenhang mit Fig. 1 gesagte.

Fig. 3 zeigt schematisch einen erfindungsgemässen Sensorkopf 2 in Sagnac-Konfiguration, wie er beispielsweise in einem Sensor gemäss Fig. 1 eingesetzt werden kann. Wie schon in Fig. 1 dargestellt, sind die zwei Zuleitungsfasern 5 über je ein Phasenverzögerungselement 4 mit je einem Ende der Sensorfaser 3 optisch verbunden. Und ein Teil jeder der Zuleitungsfasern 5 sowie die beiden Phasenverzögerungselemente 4 und die ganze Sensorfaser 3 sind innerhalb der Kapillare 6 angeordnet. Der Einfachheit halber ist der Sensorkopf 2 im gestreckten Zustand dargestellt und nicht im montierten, eine Spule bildenden Zustand.

Die Zuleitungsfasern 5 weisen vorteilhaft teilweise eine Faserschutzhülle 26 auf, welcher vorteilhaft an dem dem jeweiligen Phasenverzögerungselement 4 zugewandten Ende abgetragen ist. Die Sensorfaser 3 und vorteilhaft auch die Phasenverzögerungselemente 4 sind frei von ihren Faserschutzhüllen, so dass das den Faserkern umgebende Faser-Cladding nicht durch eine Faserschutzhülle geschützt ist. Die Kapillare 6 übernimmt im wesentlichen die Aufgabe der Faserschutzhülle, die Faser (Faser-Cladding und Faserkern) mechanisch zu schützen, wobei durch die Kapillare 6 ein deutlich besserer mechanischer Schutz möglich ist als durch die Faserschutzhülle. Die Kapillare 6 ist vorteilhaft aus Quarzglas. Da dann die Kapillare 6 denselben thermischen Ausdehnungskoeffizienten aufweist wie eine Quarzglas-Faser (insbesondere wie die Sensorfaser 3), wird dadurch der Einfluss von Temperaturänderungen minimiert. Die Sensorfaser 3 liegt lose in der Kapillare 6.

In den Zwischenraum zwischen der Faser und der Innenseite der Kapillare 6 ist das Reibungsverminderungsmittel 7, beispielsweise Silikonöl, eingebracht. Um ein Austreten des Reibungsverminderungsmittels 7 aus der Kapillare 6 zu verhindern, ist die Kapillare 6 an ihren beiden Enden mittels eines Verschliessmittels 10 verschlossen. Das Verschliessmittel 10 kann ein vorgefertigter Deckel oder besser ein Kleber 10, insbesondere ein mittels UV-Licht aushärtbarer Kleber 10 sein. Vorteilhaft weist die Faser im Bereich des Verschliessmittels 10 eine Faserschutzhülle 26 auf.

Da die Haftung zwischen einem Kleber 10 und einer mit einem ÖI benetzten Innenwand der Kapillare 6 schlecht ist, wird, wie dargestellt, vorteilhaft je ein schlauchförmiges Verlängerungsstück 11 aussen an jedem der Kapillarenenden angebracht. Ein erster Teil 11a des schlauchförmigen Verlängerungsstücks 11 umschliesst das Kapillarenende, und ein zweiter Teil 11b des schlauchförmigen Verlängerungsstücks 11 überragt das Kapillarenende in axialer Richtung, typischerweise um wenige Millimeter. Der Kleber 10 wird in den zweiten Teil 11b des schlauchförmigen Verlängerungsstücks 11 eingebracht. Selbstverständlich kann zusätzlich auch Kleber 10 innerhalb der Kapillare 6 sein. Vorteilhaft kann ein Schrumpfschlauch als schlauchförmiges Verlängerungsstück 11 benutzt werden. Vorteilhaft erfolgt das Aushärten des Klebers 10 nach dem thermischen Aufschrumpfen des Schrumpfschlauchs 11 auf die Kapillare 6.

Um die thermische Ausdehnung des Silikonöls 7 aufzunehmen ist in der Kapillare 6 auch noch ein Gas 12 angeordnet. Als das Gas 12 kann beispielsweise einfach trockene Luft oder Stickstoff genommen werden. Wie in Fig. 3 dargestellt kann die Luft 12 in Form einer an einem Ende der Kapillare 6 angeordneten Luftsäule vorliegen. Die Länge der Ölsäule wird vorteilhaft stets so gewählt, dass sie auch bei der tiefsten vorgesehenen Betriebstemperatur des Sensorkopfes 2 die Sensorfaser 3 und vorteilhaft auch die Phasenverzögerungselemente 4 noch vollständig bedeckt. Die Länge der Luftsäule wird vorteilhaft so gewählt, dass ein vorgebbarer Maximaldruck in der Kapillare 6 nicht überschritten wird.

Ein Zahlenbeispiel: Der Volumenausdehnungskoeffizient von Silikonöl liegt in der Grössenordnung von 10⁻³/°C. Eine Länge der Silikonölsäule von beispielsweise 5 m ändert sich bei Temperaturänderungen von ±50°C um ±25 cm. Soll der Maximaldruck in der Luftsäule beispielsweise auf 0.2 MPa (2 bar) beschränkt bleiben, muss die Länge der Luftsäule bei der Ausgangstemperatur mindestens 50 cm betragen, wenn vorausgesetzt wird, dass bei der Ausgangstemperatur Atmosphärendruck herrscht.

Zu ihrem äusserlichen mechanischen Schutz weist die Kapillare 6 vorteilhaft eine Kapillarenummantelung 8 auf. Diese ist vorteilhaft aus einem Polyimid. Schäden an der äusseren Kapillaroberfläche (Mikrorisse), die zu einem Bruch der Kapillare 6 bei häufigen Biegen führen könnten, werden dadurch vermieden.

Zum Schutz der Kapillare 6 und der Faser ist die Kapillare 6 und mindestens ein Teil der Zuleitungsfasern 5 in einem Faserschutzhohlkabel 9 angeordnet.

Das Faserschutzhohlkabel 9 ist mechanisch robust und schützt den Rest des Sensorkopfes 2 und gegebenenfalls die Zuleitungsfasern 5 vor mechanischen Einflüssen und Beschädigungen. Vorteilhaft ummantelt das Faserschutzhohlkabel 9 den Sensorkopf 2 und die Zuleitungsfasern 5 von und bis zum optoelektronischen Modul 13.

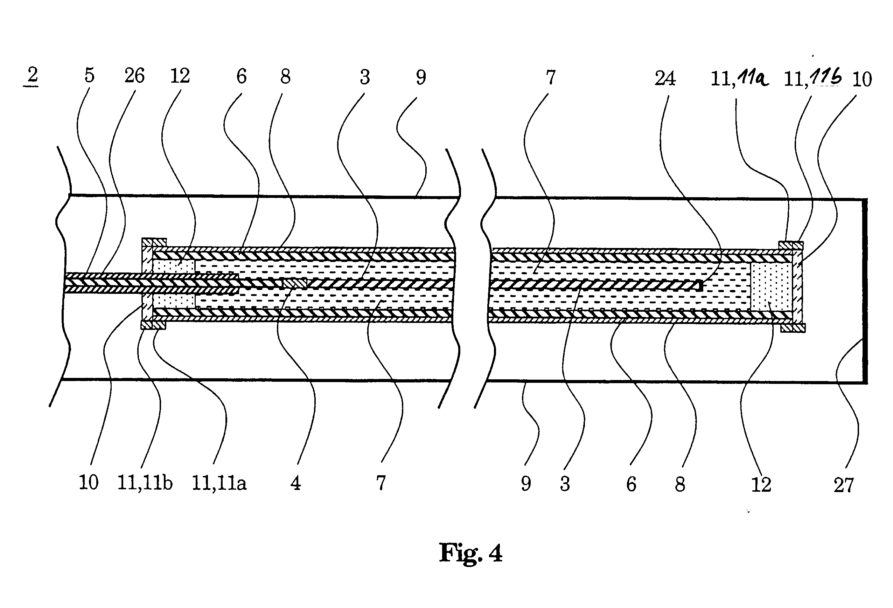

Fig. 4 zeigt, analog zu Fig. 3, einen Sensorkopf 2 in Reflex-Konfiguration, wie er beispielsweise in einem Sensor 1 gemäss Fig. 2 einsetzbar ist. Der linke Teil der Fig. 4 ist mit dem linken Teil der Fig. 3 identisch. Der rechte Teil zeigt, dass die Sensorfaser 3 an einem Ende ein Verspiegelung 24 aufweist. Das Verschliessmittel 10 im rechten Teil von Fig. 4 weist keine Öffnung für eine Zuleitungsfaser 5 auf. Und das Faserschutzhohlkabel 9 weist dort einen Faserschutzhohlkabelendverschluss 27 auf.

In Fig. 4 ist auch gezeigt, dass das Gas 12 auch in Form zweier, vorteilhaft jeweils an einem Ende der Kapillare 6 angeordneter Volumina vorgesehen sein kann. Grundsätzlich kann das Gas auch anders in der Kapillare 6 verteilt sein, beispielsweise in Form einer Vielzahl kleinerer, über die Länge der Kapillare 6 verteilter Volumina. Sehr vorteilhaft ist auch die Verwendung einer Emulsion des Gases 12 und eines flüssigen Reibungsverminderungsmittels 7, die einerseits eine gleichmässige Reibungsverminderung sicherstellt und andererseits eine geeignete Kompressibilität aufweist.

Es ist auch möglich, flüssige oder auch pulverförmige Reibungsverminderungsmittel 7 in Form von dünnen Schichten auf der Kapillareninnenseite und/oder auf der Faseraussenseite vorzusehen. Im Falle eines Öles als Reibungsverminderungsmittel 7 kann man beispielsweise das ÖI beim Einbringen der Faser in die Kapillare 6 durch die Kapillare 6 strömen lassen, so dass geeignete Schichten (Ölfilme) zurückbleiben. Im Falle von schichtförmigen Reibungsverminderungsmitteln 7 braucht die Kapillare 6 im allgemeinen nicht verschlossen zu sein.

Im Falle von Ölen als Reibungsverminderungsmittel 7 können verschiedenste Öle eingesetzt werden, die in dem vorgesehenen Betriebstemperaturbereich eine geeignete Viskosität aufweisen. Ebenfalls ist die Verwendung von Fetten als Reibungsverminderungsmittel 7 möglich. Es können auch verschiedene vorzugsweise pulverförmige Trockenschmiermittel 7 (Anti-Haft-Mittel 7) verwendet werden, beispielsweise Molybdänsulfid, Graphit oder Wolframdisulfid. Die Teilchen des Trockenschmiermittels 7 wirken dabei wie winzige Kugellager. Denkbar sind auch neuartige, nano-technologische Schmiermittel, bestehend aus einer einzigen oder aus einigen wenigen auf die Faser aufgebrachten Molekülschichten. Beispiele: Perfluoropolyether (PFPE), Kohlenstoff-Nanoröhren (carbon nano tubes, CNT), Hydroxyl-terminated perfluoropolyether (PFPE-OH). Im Falle von Trockenschmiermitteln 7 kann die Kapillare 6 in manchen Fällen unverschlossen bleiben, und im allgemeinen kann auch auf ein schlauchförmiges Verlängerungsstück 11 verzichtet werden, da viele Kleber 10 auf Trockenschmiermitteln 7 ausreichend haften, so dass der Kleber direkt in die Kapillare 6 eingebracht werden kann.

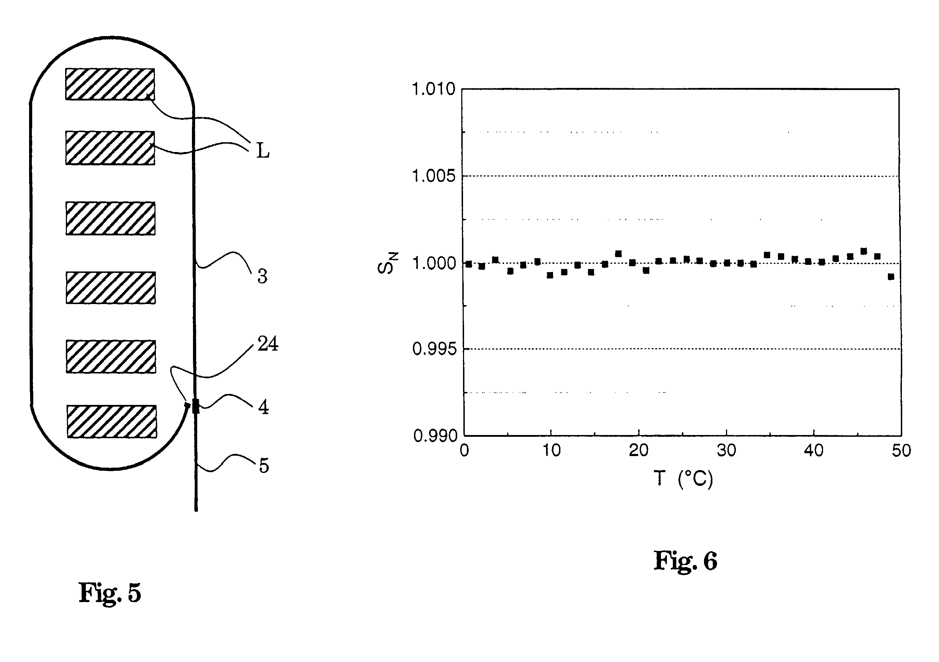

Fig. 5 zeigt schematisch einen Sensorkopf 2, welcher eine hippodromförmige Spule mit einer Windung bildet. Der Sensorkopf ist um sechs, zusammen den zu messenden Gleichstrom I führenden Stromschienen angeordnet. Durch die flexible Anordnbarkeit des erfindungsgemässen Sensorkopfes 2 sind die verschiedensten Spulengeometrien realisierbar, so dass der Sensorkopf 2 sehr variabel ist und an verschiedenste Messprobleme anpassbar ist.

Zur Montage eines erfindungsgemässen Sensorkopfes 2 wird dieser so angeordnet, dass er einen Stromleiter L, dessen Strom I zu messen ist, umschliesst oder im Bereich eines zu messenden Magnetfeldes angeordnet wird. Dazu kann der Sensorkopf 2 flexibel verformt, gebogen werden. Darum ist die Sensorfaser 2 vorteilhaft nicht bei mindestens ihrer Glasübergangstempertatur thermisch behandelt. Zur Vermeidung temperaturabhängiger Effekte durch die Faserschutzhülle ist zumindest die Sensorfaser 2 von ihrer Faserschutzhülle befreit. Durch das Biegen des Sensorkopfes 2 und insbesondere der Sensorfaser 3 bei Transport und/oder Montage ergeben sich Wechselwirkungskräfte zwischen der Faser und der Kapillarwand. Wenn die Faser deswegen an der Kapillare 6 haftet, erzeugt dies eine Doppelbrechung in der Faser, die in störendem Masse den Polarisationzustand des in der Faser geführten Lichtes verändert. Auch bei Temperaturveränderungen können solche Störungen auftreten.

Ein Zahlenbeispiel, wie beim Biegen der Kapillare infolge der Streckung beziehungsweise Stauchung der Kapillarwände mechanische Kräfte auf die Faser übertragen werden können: Kapillaren-Innendurchmesser: 0.53 mm. Die Kapillare 6 wird von einem gestreckten Zustand in eine Kreisform gebogen. Die aussen liegende Kapillarwand wird dann pro Windung um π x 0.53 mm = 1.66 mm gestreckt; die dem Kreismittelpunkt zugewandte Kapillarwand wird um den gleichen Betrag gestaucht. Bei einem Kreisdurchmesser (Spulendurchmesser) von beispielsweise 0.7 m beträgt die relative Dehnung somit 1.66 mm / (π x 700 mm) = 0.76 x 10⁻³. Bei einer Faser mit einem Durchmesser von 80 µm (typisch bei Stromsensoranwendungen) entspricht dies einer Zugspannung in axialer Richtung von 0.27 N. Da diese Kraft asymmetrisch an der Faser angreift (an der Berührungsfläche zwischen Faser und Kapillare) entsteht in der Faser ein asymmetrisches Spannungsfeld und damit verbunden eine unerwünschte Doppelbrechung.

Die Montierbarkeit des Sensorkopfes 2 ist durch die Biegbarkeit des Sensorkopfes 2 verbessert, da die Spule erst bei der Montage in die endgültige Form gebracht werden muss, sowie die Anzahl Windungen und die Spulenabmessungen und -geometrie an äussere Gegebenheiten anpassbar sind und erst nach der Herstellung des Sensorkopfes festgelegt werden müssen, und insbesondere weil ein Auftrennen eines Stromleiters L für die Montage nicht nötig ist. Ausserdem darf sich die Eichung des Sensors 1 (oder der Sensorspule 2) durch Montage und Transport nicht ändern. Zu erzielende Messgenauigkeiten liegen bei 0.1 % bis 0.2 % über einen Temperaturbereich von typischerweise 0° C bis 60° C oder -40° C bis 85° C.

Fig. 6 zeigt ein normiertes Signal S_{N} eines erfindungsgemässen Stromsensors 1 mit einer reflektiven Spule gemäss Fig. 4 als Funktion der Spulentemperatur T zwischen 0° C und 50° C. Die Sensorspule hat zwei Windungen mit einem Durchmesser von etwa 80 cm. Die Temperaturabhängigkeit des Faraday-Effekts (also die Temperaturabhängigkeit der Verdet-Konstante der Sensorfaser 2) ist kompensiert gemäss dem Verfahren, wie es in der genannten EP 1115000 beschrieben ist. Das normierte Signal S_{N} ist innerhalb von ±0.1% unabhängig von der Temperatur, was zeigt, dass mit dem erfindungsgemässen Verfahren die genannten auf der Wechselwirkung zwischen Faser und Kapillareninnenseite zurückzuführenden Störeffekte wirksam unterdrückt werden. Es werden also sehr temperaturstabile Messungen ermöglicht.

Typische Faserdurchmesser liegen bei etwa 80 µm, typische Kapillaren-Innendurchmesser bei etwa 320 µm oder 530 µm bei Kapillaren-Wandstärken von etwa 50 µm.

In einer Kapillare 6 können auch mehrere Fasern, insbesondere mehrere Sensorfasern 3 angeordnet sein. Die Zuleitungsfasern 5 können auch komplett ausserhalb der Kapillare 6 angeordnet sein. Es ist auch möglich, das oder die Phasenverzögerungselement(e) nicht in der Kapillare anzuordnen.

Gegenüber thermisch behandelten Sensorfasern 3, wie sie beispielsweise in der genannten EP 0'856'737 A1 beschrieben sind, haben die erfindungsgemässen Sensorköpfe den Vorteil, dass sie ohne grossen Aufwand auch im Falle grosser Spulen herstellbar und handhabbar sind. Für das thermische Behandeln von Spulen mit einem Durchmesser von einem Meter oder mehr würde eines unpraktikabel grossen Ofen bedürfen, und der Transport einer so grossen Spule ist sehr aufwendig.

Als Reibungsverminderungsmittel 9 kommen auch weitere Öle wie Motoren- oder Hydraulik-Öle oder Schmierfette in Frage.

Selbstverständlich kann der erfindungsgemässe Sensorkopf 2 nicht nur mit den oben beschriebenen Sensoren mit polarisationserhaltenden Zuleitungsfasern 5 und Phasenverzögerungselementen 4 verwendet werden. Als Beispiel für weitere mögliche Sensortypen, die vorteilhaft einen erfindungsgemässen Sensorkopf 2 aufweisen können seien hier Sagnac Sensoren mit 3x3-Koppler genannt, wie sie beispielsweise in J. H. Haywood et al., "Application on the NIMI Technique to the 3x3 Sagnac Fibre Current Sensor- Experimental Results", 15th Optical Fiber Sensors Conference, Portland, 6-10 May 2002, Portland, OR, USA, Technical Digest, pp 553-556 oder in K. B. Rochford et al., "Polarization dependence of response functions in 3x3 Sagnac optical fiber current sensors", J. Lightwave Technology 12, 1504-1509, 1994 beschrieben sind. In der Publikation von J. H. Haywood et al. ist eine "HiBi-spun"-Faser als Sensorfaser 3 genannt, welche aber durch eine "LowBi"-Faser mit rundem Kernquerschnitt ersetzbar ist. In der Publikation von K. B. Rochford et al. ist eine thermisch behandelte Sensorfaser 3 genannt, welche aber auch durch eine nicht thermisch behandelte Faser ersetzbar ist. Als Zuleitungsfasern 5 sind bei den Sagnac Sensoren mit 3x3-Kopplern nicht-polarisationserhaltende Fasern (vorzugsweise mit rundem Kernquerschnitt) einsetzbar. Ein Phasenverzögerungselement 4 braucht hier vom Sensorkopf 2 nicht aufgewiesen zu werden

Als anderes Beispiel für mögliche Sensortypen, die vorteilhaft einen erfindungsgemässen Sensorkopf 2 aufweisen können, seien weiterhin noch polarimetrische Sensoren genannt, wie sie beispielsweise in A. Papp, H. Harms, "Magneto-optical current transformer. 1: Principles" Applied Optics, 19, 3729-3734, 1980 oder in A. J. Rogers, et al., "Vibration immunity for optical fibre current measurement" in 10th Optical Fiber Sensors Conference, Glasgow, 11-13 October , 1994, B. Culshaw, J. Jenes Editors, Proceedings SPIE 2360, pp 40-44, 1994 beschrieben sind. Bei einem polarimetrischen Sensor ist an beiden Enden der Sensorfaser 3 je ein Polarisator angeordnet, wobei die Polarisatoren bei verschwindendem Magnetfeld zueinander unter 45° ausgerichtet sind. Typischerweise ist zwischen der Sensorfaser 3 und jeder der zwei Zuleitungsfasern 5,5' je ein Polarisator angeordnet. Die Zuleitungsfasern weisen vorteilhaft einen runden Kernquerschnitt auf. Im Falle des in der Publikation von A. Papp und H. Harms beschriebenen Sensors ist die Sensorfaser 3 gleichzeitig auch Zuleitungsfaser.

### Bezugszeichenliste

- 1: Stromsensor
- 2: Sensorkopf
- 3: Sensorfaser
- 4: Phasenverzögerungselement
- 5: Zuleitungsfaser
- 6: Kapillare
- 7: Reibungsverminderungsmittel, Öl
- 8: Kapillarenummantelung
- 9: Faserschutzhohlkabel
- 10: Verschliessmittel, Klebstoff
- 11: schlauchförmiges Verlängerungsstück
- 11a: erster Teil des schlauchförmigen Verlängerungsstücks
- 11b: zweiter Teil des schlauchförmigen Verlängerungsstücks
- 12: Gas, Luft
- 13: optoelektronisches Modul
- 14: Lichtquelle, Laser, Superluminszenszdiode
- 15: Depolarisator
- 16: Faserkoppler
- 17: Phasenmodulator
- 18: Detektor, Photodiode
- 19: Signalleitung
- 20: Signalprozessor
- 21: Steuerungsleitung
- 22: 0°-Faserspleiss oder Steckverbinder
- 23: 90°-Spleiss
- 24: Spiegel, verspiegeltes Ende
- 25: polarisationserhaltender Faserkoppler
- 26: Faserschutzhülle des Zuleitungskabels
- 27: Faserschutzhohlkabelendverschluss

- I: elektrischer Strom
- L: Stromleiter, Stromschiene
- N: Anzahl Windungen der Sensorspule
- S_{N}: normiertes Signal
- T: Temperatur

## Patentansprüche

1. Faseroptischer Sensorkopf (2) für einen Strom- oder Magnetfeldsensor (1), umfassend
- eine optische Faser, welche eine magnetooptisch aktive Sensorfaser (3) und mindestens eine Zuleitungsfaser (5) in optischer Verbindung beinhaltet, wobei die Sensorfaser (3) befreit ist von ihrer Faserschutzhülle,
- eine Kapillare (6), in welcher mindestens die Sensorfaser (3) angeordnet ist, und
- in der Kapillare (6) ein Mittel vorhanden ist,
**dadurch gekennzeichnet, dass**
- der faseroptische Sensorkopf (2) im Bereich der Sensorfaser (3) biegbar ist,
- die Sensorfaser (3) eine nicht bei mindestens der Erweichungstemperatur des Sensorfasermaterials thermisch behandelte Faser ist und
- das Mittel ein Reibungsverminderungsmittel (7) ist, das zur Verringerung von Reibungskräften zwischen der Sensorfaser (3) und der Kapillare (6) dient.

2. Sensorkopf (2) gemäss Anspruch 1, **dadurch gekennzeichnet, dass**
- ein Krümmungsradius der Sensorfaser (3) so gross gewählt ist, dass der Einfluss der durch Krümmen der Sensorfaser (3) induzierten Doppelbrechung auf die Messgenauigkeit weniger gross ist als der Einfluss solcher Doppelbrechungen, die beim Biegen des Sensorkopfes (2) zu einer Spule durch Reibungskräfte zwischen der Kapillare (6) und der in der Kapillare (6) angeordneten Sensorfaser (3) induzierbar sind, und
- diese reibungsbedingten Doppelbrechungen durch das Reibungsverminderungsmittel (7) weitgehend vermieden werden.

3. Sensorkopf (2) gemäss einem der vorangegangenen Ansprüche, **dadurch gekennzeichnet, dass** die Sensorfaser (3) im montierten Zustand einen Krümmungsradius von mindestens 0.25 m, insbesondere mindestens 0,4 m, bevorzugt mindestens 0.5 m, aufweist.

4. Sensorkopf (2) gemäss einem der vorangegangenen Ansprüche, **dadurch gekennzeichnet, dass** ein Teil der mindestens einen Zuleitungsfaser (5) innerhalb der Kapillare (6) angeordnet sind.

5. Sensorkopf (2) gemäss einem der vorangegangenen Ansprüche, **dadurch gekennzeichnet, dass** die Kapillare (6) und die Sensorfaser (3) im wesentlichen aus Quarzglas bestehen.

6. Sensorkopf (2) gemäss einem der vorangegangenen Ansprüche, **dadurch gekennzeichnet, dass** die Kapillare (6) von einer Kapillarenummantelung (8) ummantelt ist.

7. Sensorkopf (2) gemäss einem der vorangegangenen Ansprüche, **dadurch gekennzeichnet, dass** die Kapillare (6) innerhalb eines Faserschutzhohlkabels (9) angeordnet ist.

8. Sensorkopf (2) gemäss einem der vorangegangenen Ansprüche, **dadurch gekennzeichnet, dass** das Reibungsverminderungsmittel (7) eine Flüssigkeit, insbesondere ein Öl, ein Fett oder ein Pulver ist.

9. Sensorkopf (2) gemäss einem der Ansprüche 1 bis 8, **dadurch gekennzeichnet, dass** das Reibungsverminderungsmittel (7) als eine dünne reibungsvermindernde Schicht auf der Faser und/oder auf der Innenseite der Kapillare (6) vorliegt.

10. Sensorkopf (2) gemäss einem der vorangegangenen Ansprüche, **dadurch gekennzeichnet, dass**
- das Reibungsverminderungsmittel (7) ein Trockenschmiermittel (7) oder ein Anti-Haft-Mittel (7) ist, insbesondere Molybdänsulfid, Graphit oder Wolframdisulfid, oder
- das Reibungsverminderungsmittel (7) ein nano-technologisches Schmiermittel (7) ist, insbesondere Perfluoropolyether (PFPE), Kohlenstoff-Nanoröhren (CNT), Hydroxyl-terminated perfluoropolyether (PFPE-OH).

11. Sensorkopf (2) gemäss einem der vorangegangenen Ansprüche, **dadurch gekennzeichnet, dass** die Kapillare (6) an ihren Enden mittels eines Verschliessmittels (10) verschlossen ist und als Reibungsverminderungsmittel (7) eine Flüssigkeit enthält, und die Kapillare (6) zur Aufnahme temperaturbedingter Volumenänderungen des Reibungsverminderungsmittel (7) ein Gas (12) enthält.

12. Sensorkopf (2) gemäss Anspruch 11, **dadurch gekennzeichnet, dass** die Kapillare (6) eine Emulsion eines Gases (12) und eines flüssigen Reibungsverminderungsmittel (7) enthält.

13. Sensorkopf (2) gemäss einem der vorangegangenen Ansprüche, **dadurch gekennzeichnet, dass** die Kapillare (6) an ihren Enden mittels eines Klebstoffes (10) als Verschliessmittel (10) verschlossen ist.

14. Sensorkopf (2) gemäss einem der Anspruche 11 oder 13, **dadurch gekennzeichnet, dass** die Kapillare (6) an ihren Enden mit je einem schlauchförmigen Verlängerungsstück (11) versehen ist, wobei die Verlängerungsstücke (11) je einen erstenTeil (11a) aufweisen, der jeweils an einem Ende der Kapillare (6) die Kapillare (6) oder gegebenenfalls die Kapillarenummantelung (8) äusserlich umschliesst, und je einen zweiten Teil (11b) aufweisen, der das jeweilige Ende der Kapillare (6) in axialer Richtung überragt, wobei das Verschliessmittel (10) in den zweiten Teil (11b) der Verlängerungsstücke (11) eingebracht ist.

15. Sensorkopf (2) gemäss einem der vorangegangenen Ansprüche, **dadurch gekennzeichnet, dass** die optische Faser mindestens ein Phasenverzögerungselement (4) beinhaltet, welches mit der Sensorfaser (3) und der mindestens einen polarisationserhaltenden Zuleitungsfaser (5) in optischer Verbindung steht, wobei das mindestens eine Phasenverzögerungselement (4) zwischen der Sensorfaser (3) und der mindestens einen Zuleitungsfaser (5) angeordnet ist, und wobei die mindestens eine Zuleitungsfaser (5) eine polarisationserhaltende Faser ist.

16. Sensorkopf (2) gemäss Anspruch 15, **dadurch gekennzeichnet, dass** die optische Faser zwei Phasenverzögerungselemente (4,4') und zwei Zuleitungsfasern (5,5') beinhaltet, wobei zwischen der Sensorfaser (3) und jeder der zwei Zuleitungsfasern (5,5') je ein Phasenverzögerungselement (4,4') angeordnet ist.

17. Sensorkopf (2) gemäss einem der vorangegangenen Ansprüche, **dadurch gekennzeichnet, dass** in einer Kapillare (6) mehrere Sensorfasern (3) angeordnet sind.

18. Strom- oder Magnetfeldsensor (1) **dadurch gekennzeichnet, dass** der Sensor (1) einen Sensorkopf (2) gemäss einem der vorangegangenen Ansprüche aufweist.

## Claims

1. A fibre optic sensor head (2) for a current or magnetic field sensor (1), comprising
- an optical fibre, which contains a magneto-optical active sensor fibre (3) and at least one supply fibre (5) optically connected, wherein
the sensor fibre (3) is freed from its fibre protective sheath,
- a capillary (6) in which at least the sensor fibre (3) is arranged, and
- in the capillary (6) a medium is present,
**characterised in that**
- the fibre optic sensor head (2) can be bent in the region of the sensor fibre (3),
- the sensor fibre (3) is a fibre not thermally treated at at least the softening temperature of the sensor fibre material, and
- the medium is a friction-reducing medium (7), that serves for the reduction of friction forces between the sensor fibre (3) and the capillary (6).

2. The sensor head (2) according to Claim 1, **characterised in that**
- a curvature radius of the sensor fibre (3) is selected to be so large that the influence of the birefringence induced by the curvature of the sensor fibre (3) on the measurement accuracy is less large than the influence of such birefringences that can be induced by the bending of the sensor head (2) into a coil as a result of friction forces between the capillary (6) and the sensor fibre (3) arranged in the capillary (6), and
- these friction-conditioned birefringences are avoided to a large extent by the friction-reducing medium (7).

3. The sensor head (2) according to one of the previous claims, **characterised in that** the sensor fibre (3) in the installed state has a curvature radius of at least 0.25 m, in particular at least 0.4 m, preferably at least 0.5 m.

4. The sensor head (2) according to one of the previous claims, **characterised in that** a part of the at least one supply fibre (5) is arranged within the capillary (6).

5. The sensor head (2) according to one of the previous claims, **characterised in that** the capillary (6) and the sensor fibre (3) essentially consist of quartz glass.

6. The sensor head (2) according to one of the previous claims, **characterised in that** the capillary (6) is sheathed by a capillary sheath (8).

7. The sensor head (2) according to one of the previous claims, **characterised in that** the capillary (6) is arranged within a fibre protective hollow cable (9).

8. The sensor head (2) according to one of the previous claims, **characterised in that** the friction-reducing medium (7) is a fluid, in particular an oil, a grease, or a powder.

9. The sensor head (2) according to one of the Claims 1 to 8, **characterised in that** the friction-reducing medium (7) is present as a thin friction-reducing layer on the fibre and/or on the inner surface of the capillary (6).

10. The sensor head (2) according to one of the previous claims, **characterised in that**
- the friction-reducing medium (7) is a dry lubricant (7) or an anti-stick medium (7), in particular molybdenum sulphide, graphite or tungsten sulphide, or
- the friction-reducing medium (7) is a nano-technological lubricant (7) in particular perfluoropolyether (PFPE), carbon nanotubes (CNT), hydroxyl-terminated perfluoropolyether (PFPE-OH).

11. The sensor head (2) according to one of the previous claims, **characterised in that** the capillary (6) is closed at its ends by means of a closing medium (10) and contains a fluid as a friction-reducing means (7), and the capillary (6) contains a gas (12) for the accommodation of temperature-conditioned volume alterations of the friction-reducing medium (7).

12. The sensor head (2) according to Claim 11, **characterised in that** the capillary (6) contains an emulsion of a gas (12) and a fluid friction-reducing medium (7).

13. The sensor head (2) according to one of the previous claims, **characterised in that** the capillary (6) is closed at its ends by means of an adhesive as a closing medium (10).

14. The sensor head (2) according to one of the Claims 11 or 13, **characterised in that** the capillary (6) at each of its ends is provided with a hose-shaped extension piece (11), wherein
each of the extension pieces (11) has a first part (11a), which at each end of the capillary (6) externally encloses the capillary or, as necessary, the capillary sheath (8), and has a second part (11b), which overlaps the respective end of the capillary (6) in the axial direction, wherein the closing medium (10) is fitted into the second part (11b) of the extension pieces (11).

15. The sensor head (2) according to one of the previous claims, **characterised in that** the optical fibre contains at least one phase lag element (4), which is optically connected with the sensor fibre (3) and the at least one polarisation-sustaining supply fibre (5), wherein
the at least one phase lag element (4) is arranged between the sensor fibre (3) and the at least one supply fibre (5), and wherein
the at least one supply fibre (5) is a polarisation-sustaining fibre.

16. The sensor head (2) according to Claim 15, **characterised in that** the optical fibre contains two phase lag elements (4.4") and two supply fibres (5, 5"), wherein
a phase lag element (4.4") in each case is arranged between the sensor fibre (3) and each of the two supply fibres (5, 5").

17. The sensor head (2) according to one of the previous claims, **characterised in that** a plurality of sensor fibres (3) are arranged in one capillary (6).

18. A current or magnetic field sensor (1), **characterised in that** the sensor (1) has a sensor head (2) according to one of the previous claims.

## Revendications

1. Tête de détecteur (2) à fibre optique d'un détecteur de champ magnétique ou électrique (1), comprenant
- une fibre optique, qui contient une fibre de détecteur (3) active magnéto-optique et au moins une fibre d'alimentation (5) en liaison optique, moyennant quoi la fibre de détecteur (3) est dénudée de sa gaine de protection de fibre,
- un capillaire (6), dans lequel au moins la fibre de détecteur (3) est disposée, et
- un moyen est présent dans le capillaire (6),
**caractérisé en ce que**
- la tête de détecteur (2) à fibre optique est flexible au niveau de la fibre de détecteur (2),
- la fibre de détecteur (3) est une fibre qui n'est pas traitée thermiquement à au moins la température de ramollissement du matériau de fibre de détecteur et
- le moyen est un moyen de réduction de la friction (7), qui sert à diminuer les forces de friction entre la fibre de détecteur (3) et le capillaire (6).

2. Tête de détecteur (2) selon la revendication 1, **caractérisé en ce que**
- un rayon de courbure de la fibre de détecteur (3) est choisi à une grandeur telle que l'influence de la biréfringence induite par la courbure de la fibre de détecteur (3) sur la précision de mesure est moins grande que l'influence de telles biréfringences, qui peuvent être induites lors de la flexion de la tête de détecteur (2) par rapport à une bobine en raison de forces de friction entre la capillaire (6) et la fibre de détecteur (3) disposée dans le capillaire (6), et
- ces biréfringences induites par la friction sont essentiellement évitées par le moyen de réduction de la friction (7).

3. Tête de détecteur (2) selon une des revendications précédentes, **caractérisée en ce que** la fibre de détecteur (3) en l'état monté présente un rayon de courbure d'au moins 0,25 m, notamment d'au moins 0,4 m, de préférence au moins 0,5 m.

4. Tête de détecteur (2) selon une des revendications précédentes, **caractérisée en ce que** une partie d'au moins une des fibres d'alimentation (5) est disposée à l'intérieur du capillaire (6).

5. Tête de détecteur (2) selon une des revendications précédentes, **caractérisée en ce que** le capillaire (6) et la fibre de détecteur (3) sont essentiellement constitués de verre au quartz.

6. Tête de détecteur (2) selon une des revendications précédentes, **caractérisée en ce que** le capillaire (6) est enveloppé par une enveloppe de capillaire (8).

7. Tête de détecteur (2) selon une des revendications précédentes, **caractérisée en ce que** le capillaire (6) est disposé à l'intérieur d'un câble creux de protection de fibre (9).

8. Tête de détecteur (2) selon une des revendications précédentes, **caractérisée en ce que** le moyen de réduction de la friction (7) est un liquide, notamment une huile, une graisse ou une poudre.

9. Tête de détecteur (2) selon une des revendications 1 à 8, **caractérisée en ce que** le moyen de réduction de la friction (7) se présente comme une couche mince sur la fibre réduisant la friction et/ou sur la face interne du capillaire (6).

10. Tête de détecteur (2) selon une des revendications précédentes, **caractérisé en ce que**
- le moyen de réduction de la friction (7) est un lubrifiant sec (7) ou un moyen anti-adhésif (7), notamment un sulfure de molybdène, un graphite ou un disulfure de tungstène, ou
- le moyen de réduction de la friction (7) est un lubrifiant (7) nano-technologique, notamment un perfluoropolyéther (PFPE), des nanotubes de carbone (CNT), un perfluoropolyéther à terminaison hydroxyle (PFPE-OH).

11. Tête de détecteur (2) selon une des revendications précédentes, **caractérisée en ce que** le capillaire (6) est obturé à ses extrémités au moyen d'un moyen d'obturation (10) et contient comme moyen de réduction de la friction (7) un liquide, et le capillaire (6) contient un gaz (12) afin d'absorber les variations de volume du moyen de réduction de la friction (7), induites par la température.

12. Tête de détecteur (2) selon la revendication 11, **caractérisé en ce que** le capillaire (6) contient une émulsion d'un gaz (12) et d'un moyen de réduction de la friction (7) liquide.

13. Tête de détecteur (2) selon une des revendications précédentes, **caractérisée en ce que** le capillaire (6) est obturé à ses extrémités au moyen d'une colle (10) faisant office de moyen d'obturation (10).

14. Tête de détecteur (2) selon une des revendications 11 ou 13, **caractérisée en ce que** le capillaire (6) à ses extrémités est respectivement pourvu d'une pièce d'allongement (11) en forme de tuyau flexible, moyennant quoi les pièces d'allongement (11) présentent chacune une première partie (11a), qui enveloppe respectivement extérieurement, à une extrémité du capillaire (6), le capillaire (6) ou le cas échéant l'enveloppe du capillaire (8), et présentent chacune une deuxième partie (11a), qui dépasse de l'extrémité respective du capillaire (6) dans la direction axiale, moyennant quoi le moyen d'obturation (10) est logé dans la deuxième partie (11b) des pièces d'allongement (11).

15. Tête de détecteur (2) selon une des revendications précédentes, **caractérisée en ce que** la fibre optique contient au moins un élément de retard de phase (4), qui est en liaison optique avec la fibre de détecteur (3) et au moins une fibre d'alimentation (5) conservant la polarisation, moyennant quoi au moins un élément de retard de phase (4) est disposé entre la fibre de détecteur (3) et au moins une fibre d'alimentation (5), et moyennant quoi au moins une fibre d'alimentation (5) est une fibre conservant la polarisation.

16. Tête de détecteur (2) selon la revendication 15, **caractérisée en ce que** la fibre optique contient deux éléments de retard de phase (4,4') et deux fibres d'alimentation (5,5'), moyennant quoi entre la fibre de détecteur (3) et chacune des deux fibres d'alimentation (5,5'), un élément de retard de phase (4,4') est respectivement disposé.

17. Tête de détecteur (2) selon une des revendications précédentes, **caractérisée en ce que** dans un capillaire (6), plusieurs fibres de détecteur (3) sont disposées.

18. Détecteur de champ magnétique ou électrique (1), **caractérisé en ce que** le détecteur (1) présente une tête de détection (2) selon une des revendications précéden tes.
